(19) **Europäisches Patentamt**

**European Patent Office**

**Office européen des brevets**

(11) **EP 0 981 199 A2**

(12) **EUROPÄISCHE PATENTANMELDUNG**

(43) Veröffentlichungstag:
**23.02.2000 Patentblatt 2000/08**

(51) Int. Cl.$^{7}$: **H03H 11/12**

(21) Anmeldenummer: **99202613.8**

(22) Anmeldetag: **10.08.1999**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **19.08.1998 DE 19837574**

(71) Anmelder:
• **Philips Corporate Intellectual Property GmbH 52064 Aachen (DE)**
Benannte Vertragsstaaten:
**DE**

• **Koninklijke Philips Electronics N.V. 5621 BA Eindhoven (NL)**
Benannte Vertragsstaaten:
**FR GB IT**

(72) Erfinder: **Gehrt, Holger**
**Röntgenstrasse 24, 22335 Hamburg (DE)**

(74) Vertreter:
**Peters, Carl Heinrich et al**
**Philips Corporate Intellectual Property GmbH,**
**Habsburgerallee 11**
**52064 Aachen (DE)**

(54) **Aktive elektronische Filterschaltung**

(57)     Beschrieben wird eine aktive elektronische Filterschaltung, umfassend

- wenigstens einen Filtereingang,
- wenigstens ein Verstärkerelement mit wenigstens einem Verstärkereingang und zu wenigstens einem der Filtereingänge und wenigstens einem der Verstärkereingänge ein die Filtercharakteristik bestimmendes Netzwerk, welches eine Eingangsimpedanzanordnung zum Verbinden des Filtereingangs mit dem Verstärkereingang aufweist.

Um bei einer solchen Filterschaltung eine Eingangsimpedanzanordnung mit hohem Impedanzwert zu schaffen, die sich auf einem Halbleiterkristall mit hoher Genauigkeit und geringem Verbrauch an Kristallfläche herstellen läßt, ist erfindungsgemäß vorgesehen, daß die Eingangsimpedanzanordnung wenigstens ein T-Glied mit wenigstens drei Impedanzzweigen umfaßt, von denen ein erster Impedanzzweig mit dem Filtereingang, ein zweiter Impedanzzweig mit dem Verstärkereingang und ein dritter Impedanzzweig mit einem Schaltungspunkt zur Aufnahme eines Stromes vom Filtereingang verbunden ist.

FIG.3

EP 0 981 199 A2

## Beschreibung

Die Erfindung bezieht sich auf eine aktive elektronische Filterschaltung, umfassend

- wenigstens einen Filtereingang,
- wenigstens ein Verstärkerelement mit wenigstens einem Verstärkereingang und zu wenigstens einem der Filtereingänge und wenigstens einem der Verstärkereingänge ein die Filtercharakteristik bestimmendes Netzwerk, welches eine Eingangsimpedanzanordnung zum Verbinden des Filtereingangs mit dem Verstärkereingang aufweist.

Aus der US-PS 4,509,019 ist ein abstimmbares Hochpaß- oder Tiefpaßfilter bekannt, welches einen Gegentaktverstärker umfaßt, der elektronisch steuerbare Elemente entweder in den beiden Eingangszweigen oder den beiden Rückkopplungszweigen (oder sowohl in den Eingangszweigen und den Rückkopplungszweigen) enthält. Ein Reaktanzelement ist jeweils im anderen der Zweige angeordnet. Durch diese Anordnung soll eine geringe Verzerrung erreicht werden, was eine einfache Integration auf einem Halbleiterkörper mit einem nichtlinearen Element, beispielsweise einem MOS-Transistor, als spannungssteuerbares Element ermöglicht.

Es zeigt sich, daß diese bekannte Filterschaltung den Nachteil aufweist, daß die Zeitkonstante, die mit einer solchen Filterschaltung erreichbar ist, nur über einen relativ geringen Aussteuerbereich einstellbar ist, da die Widerstandswerte der als steuerbare Elemente verwendeten MOS-Transistoren nur über einen vergleichsweise kleinen Aussteuerungsbereich variiert werden können.

Aus der US-PS 4,780,690 ist eine Filteranordnung bekannt, deren Zeitkonstante über einen vergleichsweise weiten Bereich einstellbar sein soll. Diese Filteranordnung umfaßt einen Gegentaktverstärker, der einen invertierenden Eingang, einen nichtinvertierenden Eingang, einen invertierenden Ausgang, einen nichtinvertierenden Ausgang, einen ersten Eingangsanschluß und einen zweiten Eingangsanschluß, einen ersten Rückkopplungskreis, der einen ersten Kondensator umfaßt und zwischen dem nichtinvertierenden Ausgang und dem invertierenden Eingang angeordnet ist, und einen zweiten Rückkopplungskreis, der einen zweiten Kondensator umfaßt, der im wesentlichen identisch zu dem ersten Kondensator und zwischen dem invertierenden Ausgang und dem nichtinvertierenden Eingang angeordnet ist, enthält. Diese bekannte Filteranordnung enthält ferner einen Transkonduktanzkreis mit variabler Transkonduktanz, der zwei Eingänge umfaßt, die mit den Eingangsanschlüssen der Filteranordnung verbunden sind, sowie zwei Ausgänge, die mit dem invertierenden und dem nichtinvertierenden Eingang des Verstärkers verbunden sind. Als Transkonduktanzkreis ist dabei eine spannungsgesteuerte Stromquelle bezeichnet, durch die eine Gegentakt-Eingangsspannung in einen Gegentakt-Ausgangsstrom umgewandelt wird. Der Proportionalitätsfaktor zwischen dem Ausgangsstrom und der Eingangsspannung wird durch die Transkonduktanz vorgegeben. Im allgemeinen kann diese Transkonduktanz über einen vergleichsweise weiten Bereich variiert werden, wodurch die Zeitkonstante der bekannten Filteranordnung über einen vergleichsweise weiten Bereich variiert werden können soll.

Der Transkonduktanzkreis gemäß der Filteranordnung nach US-PS 4,780,690 enthält eine Mehrzahl aktiver Elemente, von denen jedes einen Steuereingang und einen ersten und einen zweiten Ausgangsanschluß aufweist. Die Steuereingänge von wenigstens zwei der genannten aktiven Elemente sind mit den Eingangsanschlüssen der genannten Filteranordnung verbunden. Die ersten Ausgangsanschlüsse der genannten, wenigstens zwei aktiven Elemente sind unmittelbar miteinander und die zweiten Ausgangsanschlüsse dieser beiden aktiven Elemente sind mir dem genannten invertierenden bzw. dem nichtinvertierenden Verstärkereingang verbunden.

Die aus der US-PS 4,780,690 bekannte Filteranordnung enthält ferner eine Lastschaltung zur Belastung des Transkonduktanzkreises. Diese Lastschaltung umfaßt einen ersten und einen zweiten Stromquellentransistor, deren miteinander verbundene Basisanschlüsse über eine Diode mit einem Verbindungspunkt zweier Widerstände verbunden sind, die zwischen den Ausgängen des Transkonduktanzkreises angeordnet sind.

Aus der US-PS 4,780,690 ist es weiterhin bekannt, einen Transkonduktanzkreis mit MOS-Transistoren aufzubauen. Auch diesem Transkonduktanzkreis wird ein vergleichsweise großer linearer Spannungsbereich zugeschrieben.

Die Erfindung hat die Aufgabe, bei einer aktiven elektronischen Filterschaltung eine Eingangsimpedanzanordnung mit hohem Impedanzwert zu schaffen, die sich auf einem Halbleiterkristall mit hoher Genauigkeit und geringem Verbrauch an Kristallfläche herstellen läßt.

Erfindungsgemäß wird diese Aufgabe bei einer aktiven elektronischen Filterschaltung der eingangs genannten Art dadurch gelöst, daß die Eingangsimpedanzanordnung wenigstens ein T-Glied mit wenigstens drei Impedanzzweigen umfaßt, von denen ein erster Impedanzzweig mir dem Filtereingang, ein zweiter Impedanzzweig mit dem Verstärkereingang und ein dritter Impedanzzweig mir einem Schaltungspunkt zur Aufnahme eines Stromes vom Filtereingang verbunden ist.

Durch die Ausbildung der Eingangsimpedanzanordnung mit einem T-Glied wird ein Impedanzzweig zur Verfügung gestellt, durch den ein Teil eines dem Filtereingang bzw. den Filtereingängen zugeführten Signalstromes am zugehörigen Verstärkereingang bzw. an den zugehörigen Verstärkereingängen vorbei geleitet wird. Dadurch steht dieser Teil des Signalstromes in dem die Filtercharakteristik bestimmenden Netzwerk nicht weiter zur Verfügung und die effektive wirksame Eingangsimpedanz am Filtereingang bzw. an den Filtereingängen erhöht sich entsprechend. Als Schaltungspunkt zur Aufnahme dieses Stromes vom Filtereingang bzw. den Filtereingängen kann ein der Schaltung gemeinsamer Masseanschluß dienen.

In einer vorteilhaften Ausgestaltung der Erfindung ist eine aktive elektronische Filterschaltung mit zwei Filtereingängen und einem Verstärkerelement mit zwei Verstärkereingängen in der Weise ausgebildet, daß die Eingangsimpedanzanordnung wenigstens ein T-Glied umfaßt, in welchem je ein erster, zweiter, dritter bzw. vierter Impedanzzweig mit dem ersten bzw. zweiten der Filtereingänge bzw. dem ersten bzw. zweiten der Verstärkereingänge verbunden ist und der erste und dritte Impedanzzweig einerseits mit dem zweiten und vierten Impedanzzweig andererseits über einen fünften Impedanzzweig verbunden sind.

Eine derartige aktive elektronische Filterschaltung ist bevorzugt als Gegentaktschaltung mit einem Gegentakt-Verstärkerelement aufgebaut. Dabei wird der an den Verstärkereingängen vorbei geleitete Teil des Signalstromes von einem der Filtereingänge zum anderen Filtereingang über den fünften Impedanzzweig abgeleitet, so daß ein gesonderter Schaltungspunkt zur Aufnahme dieses Stromes nicht erforderlich ist. Vielmehr dient einer der Filtereingänge als ein solcher Schaltungspunkt, und die Eingangsimpedanzanordnung der aktiven elektronischen Filterschaltung in dieser Ausbildung kann bevorzugt potentialfrei betrieben werden.

In einer weiteren Ausgestaltung der erfindungsgemäßen aktiven elektronischen Filterschaltung umfaßt die Eingangsimpedanzanordnung wenigstens zwei T-Glieder in Kettenschaltung. Mit geringem Schaltungsaufwand läßt sich so eine weitere, bedeutende Erhöhung des Impedanzwertes der Eingangsimpedanzanordnung erzielen.

In einer anderen Ausgestaltung der Erfindung ist das T-Glied bzw. sind die T-Glieder bezüglich der Filtereingänge und/oder der Verstärkereingänge symmetrisch aufgebaut. Dieser symmetrische Aufbau ist insbesondere bei Gegentaktschaltungen angezeigt.

Nach einer anderen Fortbildung der Erfindung sind die Impedanzzweige im wesentlichen aus ohmschen Elementen gebildet; insbesondere können wenigstens einige der Impedanzzweige steuerbar, im wesentlichen ohmsche Elemente umfassen. Bevorzugt sind die steuerbaren, im wesentlichen ohmschen Elemente innerhalb je eines T-Gliedes symmetrisch angeordnet. Mit steuerbaren, im wesentlichen ohmschen Elementen, bevorzugt mit MOS-Transistoren ausgebildet, kann die Filtercharakteristik der erfindungsgemäßen aktiven elektronischen Filterschaltung auf vorteilhafte Weise eingestellt und präzise abgeglichen werden. Bei der Verwendung von MOS-Transistoren ist dies in an sich bekannter Weise mit Steuerspannungen möglich.

Eine bevorzugte Ausbildung einer aktiven elektronischen Filterschaltung gemäß der Erfindung stellt der Fall dar, daß das die Filtercharakteristik bestimmende Netzwerk als Integrationsstufe - in Zusammenwirken mit dem Verstärkerelement - ausgebildet ist. Bei einer solchen Integrationsstufe ist die Eingangsimpedanzanordnung bevorzugt rein ohmsch ausgebildet.

Aktive elektronische Filterschaltungen gemäß der Erfindung sind in allen Geräten der elektronischen Nachrichtentechnik vorteilhaft einsetzbar, da sie durch ihre Integrierbarkeit auf einem Halbleiterkörper der Miniaturisierung dieser Geräte dienen. Zugleich kann ihre Fitercharakteristik derart präzise eingestellt werden, daß eine hohe Qualität der Signalverarbeitung erreichbar ist.

Die Zeichnung, in deren Figuren übereinstimmende Elemente mit denselben Bezugszeichen versehen sind, stellt ein Ausführungsbeispiel der Erfindung dar. Im einzelnen zeigen

Fig. 1 ein Gegentakt-Integratorfilter als Beispiel einer aktiven elektronischen Filterschaltung mit einem aus der US-PS 4,509,019 abgeleiteten Aufbau,
Fig. 2 eine Variation der Filterschaltung gemäß Fig. 1 und
Fig. 3 ein Gegentakt.-Integratorfilter als Ausführungsbeispiel einer erfindungsgemäßen aktiven elektronischen Filterschaltung.

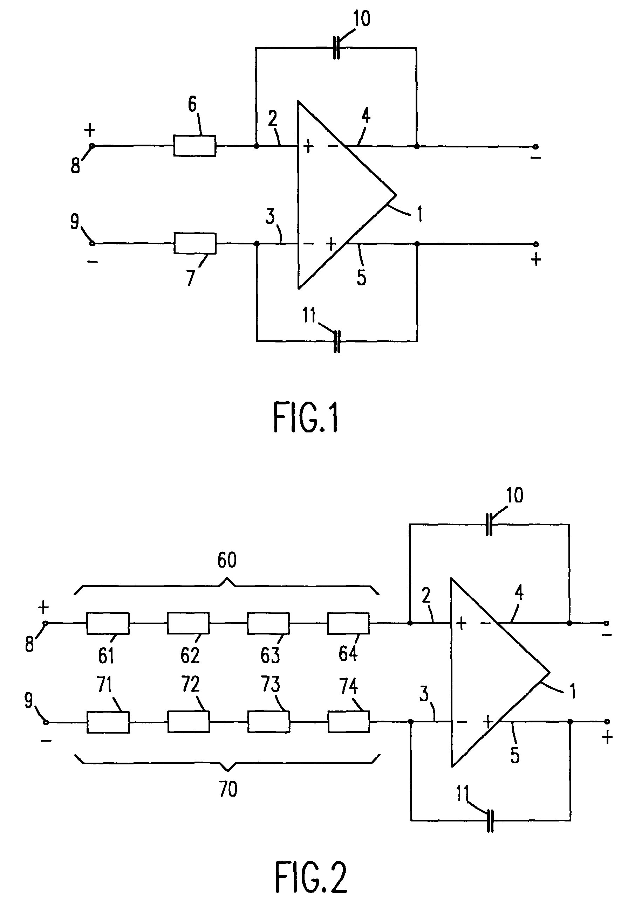

Die vorliegende Erfindung soll am Beispiel eines zweipoligen Gegentakt-Integratorfilters näher erläutert werden. Ein derartiges Integratorfilter zeigt Fig. 1. Dieses Integatorfilter umfaßt ein Verstärkerelement 1 mit einem nichtinvertierenden Verstärkereingang 2, einem invertierenden Verstärkereingang 3, einem invertierenden Verstärkerausgang 4 und einem nichtinvertierenden Verstärkerausgang 5. Ein die Filtercharakteristik des Gegentakt Integrator filters bestimmendes Netzwerk weist eine Eingangsimpedanzanordnung auf; die einen ersten ohmschen Widerstand 6 und einen zweiten ohmschen Widerstand 7 umfaßt. Der erste ohmsche Widerstand 6 verbindet einen ersten Filtereingang 8 mit dem nichtinvertierenden Verstärkereingang 2, und der zweite ohmsche Widerstand 7 verbindet einen zweiten Filtereingang 9 mit dem invertierenden Verstärkereingang 3. Das die Filtercharakteristik des Gegentakt-Integratorfilters bestimmende Netzwerk umfaßt weiterhin zwei Kapazitäten, von denen eine erste mit dem Bezugszeichen 10 einen Rückkopplungszweig zwischen dem invertierenden Verstärkerausgang 4 und dem nichtinvertierenden Verstärkereingang 2 bildet, wohingegen durch die zweite Kapazität 11 ein Rückkopplungszweig zwischen dem nichtinvertierenden Verstärkerausgang 5 und dem invertierenden Verstärkereingang 3 gebildet wird. Die Verstärkerausgänge 4, 5 bilden außerdem Ausgänge des Gegentakt-Integratorfilters nach Fig. 1.

Bei Verwendung von geregelten Komponenten läßt sich gemäß Fig. 1 ein GegentaktIntegratorfilter mit hoher Präzision aufbauen, welches außerdem vollständig auf einem Halbleiterkörper integriert werden kann. Als geregelte Komponenten, d.h. in ihren Kenndaten steuerbare Schaltungselemente, bieten sich vorzugsweise MOS-Transistoren an, mit denen die ohmschen Widerstände 6, 7 aufgebaut werden können. Dies ist grundsätzlich aus der US-PS 4,509,019 bekannt.

Bei der Dimensionierung einer derart aufgebauten aktiven elektronischen Filterschaltung, beispielsweise eines Gegentakt-Integratorfilters, wird im Prinzip derart vorgegangen, daß aus der vorgegebenen Spezifikation für das zu schaffende Filter ein sogenanntes Prototyp-Filter entwickelt wird. Dieses wird in eine ideale Filtervariante, im vorliegenden Beispiel eine ideale Variante eines Gegentakt-Integratorfilters, umgesetzt, mit der Annahme idealer Schaltungselemente. Dafür ist ein Werteniveau für die Dimensionierung der Werte der einzusetzenden ohmschen Widerstände und Kapazitäten zu wählen. Diese Wahl wird abhängig von Vorgaben für die zu realisierende Filterschaltung vorgenommen. Als solche Vorgaben treten insbesondere der Signal-Rausch-Abstand und der Stromverbrauch der Filterschaltung hervor.

Aus diesen Vorgaben ergibt sich ein passender Basis-Widerstand, der als Normwert für die zu realisierenden ohmschen Widerstände und gegebenenenfalls auch für die zu realisierenden Kapazitäten herangezogen werden kann. Die Kenndaten der Elemente der aufzubauenden Filterschaltung werden dann auf diesen Basis-Widerstand normiert.

Methoden zur Synthese aktiver elektronischer Filterschaltungen sind grundsätzlich aus der Literatur bekannt, so beispielsweise aus der Monographie von R. Schaumann, M.S. Ghausi und K.R. Laker: „Design of Analog Filters", erschienen bei Prentice Hall, 1990.

Aus Gründen der bei der Dimensionierung einer derartigen Filterschaltung gewünschten Genauigkeit wird versucht, für alle ihre Elemente möglichst Werte zu wählen, die wenigstens nahezu dem genannten Basis-Widerstand entsprechen. Je nach zu realisierendem Filtertyp und vorgegebener Spezifikation ist dies jedoch nicht überall möglich. Oft ergeben sich für die Dimensionierung einzelner Elemente große Abweichungen vom durch den Basis-Widerstand vorgegebenen Wert. Es kann dann versucht werden, diese abweichenden Werte durch Parallel- oder Serienschaltung von gemäß dem Wert des Basis-Widerstands dimensionierten Elementen zu erzeugen. Sollen zum Beispiel Elemente mit hohen ohmschen Widerstandswerten erzeugt werden, wird dies durch Serienschaltung einzelner ohmscher Widerstandselemente verwirklicht, die jeweils einen Widersrandswert entsprechend dem Basis-Widerstand aufweisen.

Ein Beispiel für ein in dieser Weise aufgebautes Gegentakt-Integratorfilter ist in Fig. 2 dargestellt. Für dessen Filtercharakteristik ist ein hoher Eingangswidersrand erforderlich. Um einen solchen zu erreichen, umfaßt die Eingangsimpedanzanordnung als ersten bzw. zweiten ohmschen Widerstand 60 bzw. 70 je eine Serienschaltung von im gezeigten Beispiel vier Widerstandselementen 61, 62, 63, 64 bzw. 71, 72, 73, 74, die jedes den normierten Wert des Basis-Widerstands aufweisen. Somit haben der erste bzw. der zweite ohmsche Widerstand 60 bzw. 70 im Ausführungsbeispiel gemäß Fig. 2 je den vierfachen Widerstandswert eines Widerstandselements 61, 62, 63, 64, 71, 72, 73, bzw. 74. Für die Erhöhung des Eingangswidersrands auf das Vierfache ist somit auch ein vierfacher Schaltungsaufwand erforderlich.

Diese Art der Realisierung ist durch die große Anzahl der Schaltungselemente, die proportional zu dem gewünschten Widerstandswert in der Eingangsimpedanzanordnung zunimmt, sehr aufwendig. Außerdem nimmt mit der Anzahl der Schaltungselemente auch die Anzahl der darin wirksamen, parasitären Kapazitäten zu, insbesondere auch, wenn die Widerstandselemente in der Form von MOS-Transistoren gestaltet werden. Derartige parasitäre Kapazitäten wirken sich sehr nachteilig aufdie gewünschte Filtercharakteristik insbesondere im höherfrequenten Bereich aus. Es ist daher ein Aufbau der Eingangsimpedanzanordnung anzustreben, der es ermöglicht, hohe Widerstandswerte mit verhältnismäßig wenigen Widerstandselementen aufzubauen.

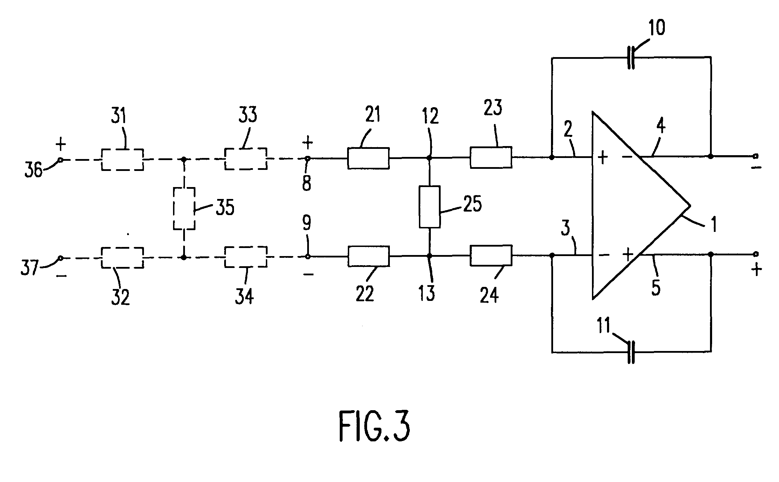

Ein Ausführungsbeispiel für die erfindungsgemäße Lösung dieses Problems zeigt Fig. 3. Der Aufbau der in dieser Filterschaltung eingesetzten Eingangsimpedanzanordnung beruht auf der Grundidee, den Filtereingängen 8, 9 zugeführte Ströme an den für die Filtercharakteristik wirksamen Verstärkereingängen 2, 3 vorbei zu leiten. Dies wird dadurch erreicht, daß die Eingangsimpedanzanordnung im vorliegenden Ausführungsbeispiel ein T-Glied mit fünf Impedanzzweigen umfaßt. Ein erster dieser Impedanzzweige mit dem Bezugszeichen 21 ist einerseits mit dem ersten Filtereingang 8 und andererseits mit einem ersten Verbindungspunkt 12 verbunden. Ein zweiter der Impedanzzweige mit dem Bezugszeichen 22 ist zwischen diesem ersten Verbindungspunkt 12 und dem nichtinvertierenden (ersten) Verstärkereingang 2 angeordnet. Entsprechend ist ein dritter dieser Impedanzzweige mit dem Bezugszeichen 23 zwischen dem zweiten Filtereingang 9 und einem zweiten Verbindungspunkt 13 angeordnet, von dem über einen vierten der Impedanzzweige mit dem Bezugszeichen 24 eine Verbindung zum invertierenden (zweiten) Verstärkereingang 3 besteht. Zwischen beiden Verbindungspunkten 12, 13 ist ein fünfter der Impedanzzweige mit dem Bezugszeichen 25 eingefügt.

Die so gebildete Eingangsimpedanzanordnung weist eine T-Struktur auf, die dafür sorgt, daß ein Teil eines über die Filtereingänge 8, 9 fließenden Signalstromes am virtuellen Nullpunkt des Verstärkerelements 1 vorbei geleitet wird. Dadurch steht dieser Teil des Signalstromes nicht zum Laden bzw. Entladen der Kapazitäten 10, 11 zur Verfügung und der effektiv wirksame Eingangswiderstand des abgebildeten Gegentakt-Integratorfilters erhöht sich entsprechend. Die Berechnung des effektiv wirksamen Wertes für den Eingangswiderstand an den Filtereingängen 8 bzw. 9 mit Hilfe der Netzwerkanalyse ergibt für eine Filterschaltung nach den Fig. 1 oder 2 den Wert des ohmschen Widerstands 6, 7, 60 bzw. 70, also für eine Anordnung gemäß Fig. 2 die Summe der Widerstandselemente 61 bis 64 bzw. 71 bis 74 in einem der Zweige zwischen einem der Filtereingänge 8 bzw. 9 und dem damit verbundenen Verstärkereingang 2 bzw. 3. Für die Filterschaltung gemäß Fig. 3 berechnet sich dieser effektiv wirksame Eingangswiderstand Reff gemäß der Formel

$$\text{Reff} = R21 + R23 + 2 \cdot R21 \cdot R23/R25$$

Diese Gleichung ergibt sich unter der Voraussetzung, daß alle Impedanzzweige 21 bis 25 mir ohmschen Widerständen ausgebildet sind und zur Erreichung eines symmetrischen Aufbaus für die Filterschaltung die Widersrandswerte des ersten und des zweiten Impedanzzweiges 21, 22 miteinander übereinstimmen und auch die Widerstandswerte im dritten und vierten Impedanzzweig 23, 24 einander gleich sind.

Werden beispielsweise die Widerstandselemente 61 bis 64 und 71 bis 74 in Fig. 2 sowie die die Impedanzzweige 21 bis 25 des T-Gliedes in Fig. 3 bildenden ohmschen Widerstände mit übereinstimmenden Widersrandswerten dimensioniert, zeigt sich, daß die effektiv wirksamen Eingangswiderstände bezüglich der Filtereingänge 8 bzw. 9 in den Filterschaltungen der Fig. 2 und 3 übereinstimmen. Allerdings können in der erfindungsgemäßen Ausbildung der Fig. 3 gegenüber der Ausführung nach Fig. 2 drei Widersrandselemente eingespart werden.

Durch unterschiedliche Wahl der Widerstandswerte für die Impedanzzweige 21 bis 25 kann die Eingangsimpedanzanordnung gemäß Fig. 3 auch für andere, insbesondere für höhere effektiv wirksame Widersrandswerte des Eingangswiderstands bezüglich der Filtereingänge 8, 9 dimensioniert werden. Dabei ist es in vorteilhafter Weise möglich, die Impedanzzweige weitgehend mir dem Widerstandswert des Basis-Widerstands oder kleiner Vielfacher desselben zu dimensionieren. Die Impedanzzweige 21 bis 25 können dann zumindest weitgehend aus identischen Widersrandselementen zusammengefügt werden. Für einzelne der Impedanzzweige 21 bis 25 können für einige Dimensionierungsbeispiele von einem ganzzahligen Vielfachen des Widerstandswerts des Basis-Widerstands abweichende Widerstandswerte notwendig werden, die sich jedoch in ihrer Dimensionierung nur verhältnismäßig gering von dem Basis-Widerstand unterscheiden.

Dadurch, daß gemäß der erfindungsgemäßen Ausbildung der aktiven elektronischen Filterschaltung in ihrer Eingangsimpedanzanordnung eine geringere Anzahl von Schaltungselementen benötigt wird, lassen sich auch die durch diese verursachten, parasitären Effekte verringern. Außerdem wird ein kompakterer, Kristallfläche einsparender Aufbau erhalten.

Eine Erweiterung des Ausführungsbeispiels der Erfindung nach Fig. 3 ist dort gestrichelt dargestellt. Diese Erweiterung umfaßt ein weiteres T-Glied, welches mit je einem ersten, zweiten, dritten, vierten bzw. fünften Impedanzzweig 31, 32, 33, 34 bzw. 35 entsprechend dem ersten T-Glied 21 bis 25 aufgebaut ist. Als Filtereingänge der so erweiterten Filterschaltung dienen Anschlüsse 36 bzw. 37. Das weitere T-Glied 31 bis 35 ist zu dem ersten T-Glied 21 bis 25 in Kettenschaltung angeordnet.

In den T-Gliedern können bevorzugt die ersten, zweiten, dritten und vierten Impedanzzweige als steuerbare, ohmsche Elemente, bevorzugt als MOS-Transistoren, ausgebildet sein. Insbesondere kann deren Steuerung paarweise erfolgen.

In einer nicht dargestellten Abwandlung kann die Erfindung auch auf unsymmetrische Filterschaltungen Anwendung finden. Ein einfaches Beispiel dafür wäre eine Filterschaltung mit lediglich einem Filtereingang, die ein Verstärkerelement mit nur einem Verstärkereingang und nur einem Verstärkerausgang enthält. Bei einer Ausbildung als Integratorfilter könnte eine solche, bekannte Filterschaltung in Abwandlung der Fig. 1 beispielsweise nur den ersten ohmschen Widerstand 6 und die erste Kapazität 10 aufweisen. In erfindungsgemäßer Ausbildung der aktiven elektronischen Filterschaltung mit einem einzigen Filgereingang könnte die Eingangsimpedanzanordnung einen ersten Impedanzzweig zwischen dem einzigen Filtereingang und einem Verbindungspunkt, einen zweiten Impedanzzweig zwischen diesem Verbindungspunkt und dem einzigen Verstärkereingang und einen dritten Impedanzzweig zwischen dem Verbindungspunkt und Masse aufweisen. Ein Teil des dem Filtereingang zugeführten Signalstromes wird dann über den dritten Impedanzzweig an Masse abgeleitet und erreicht den Verstärkereingang nicht.

In entsprechender Weise können außer Integratorfiltern auch Filterschaltungen mit anderen Filtercharakteristiken erfindungsgemäß ausgebildet sein.

Mit der Erfindung kann bei Integratorfiltern insbesondere der Schwierigkeit, große Werte für die RC-Zeitkonstanten mit hinreichender Genauigkeit zu dimensionieren, auf einfache und wirksame Weise begegnet werden. Bei verringertem Schaltungsaufwand und geringerer, benötigter Kristallfläche ist damit eine höhere Dimensionierungsgenauigkeit und ein geringerer Einfluß parasitärer Elemente erzielbar.

**Patentansprüche**

1. Aktive elektronische Filterschaltung, umfassend

- wenigstens einen Filtereingang,
- wenigstens ein Verstärkerelement mit wenigstens einem Verstärkereingang und zu wenigstens einem der Filtereingänge und wenigstens einem der Verstärkereingänge ein die Filtercharakteristik bestimmendes Netzwerk, welches eine Eingangsimpedanzanordnung zum Verbinden des Filtereingangs mit dem Verstärkereingang aufweist,
  <u>dadurch gekennzeichnet,</u>
  daß die Eingangsimpedanzanordnung wenigstens ein T-Glied mit wenigstens drei Impedanzzweigen umfaßt, von denen ein erster Impedanzzweig mit dem Filtereingang, ein zweiter Impedanzzweig mit dem Verstärkereingang und ein dritter Impedanzzweig mit einem Schaltungspunkt zur Aufnahme eines Stromes vom Filtereingang verbunden ist.

2. Aktive elektronische Filterschaltung nach Anspruch 1 mit zwei Filtereingängen und einem Verstärkerelement mit zwei Verstärkereingängen, <u>dadurch gekennzeichnet</u>, daß die Eingangsimpedanzanordnung wenigstens ein T-Glied umfaßt, in welchem je ein erster, zweiter, dritter bzw. vierter Impedanzzweig mit dem ersten bzw. zweiten der Filtereingänge bzw. dem ersten bzw. zweiten der Verstärkereingänge verbunden ist und der erste und dritte Impedanzzweig einerseits mit dem zweiten und vierten Impedanzzweig andererseits über einen fünften Impedanzzweig verbunden sind.

3. Aktive elektronische Filterschaltung nach Anspruch 2, <u>dadurch gekennzeichnet</u>, daß die Eingangsimpedanzanordnung wenigstens zwei T-Glieder in Kettenschaltung umfaßt.

4. Aktive elektronische Filterschaltung nach Anspruch 2 oder 3, <u>dadurch gekennzeichnet,</u>
daß das T-Glied bzw. die T-Glieder bezüglich der Filtereingänge und/oder der Verstärkereingänge symmetrisch aufgebaut ist bzw. sind.

5. Aktive elektronische Filterschaltung nach einem der vorhergehenden Ansprüche,
<u>dadurch gekennzeichnet,</u>
daß die Impedanzzweige im wesentlichen aus ohmschen Elementen gebildet sind.

6. Aktive elektronische Filterschaltung nach einem der vorhergehenden Ansprüche,
<u>dadurch gekennzeichnet,</u>
daß wenigstens einige der Impedanzzweige steuerbare, im wesentlichen ohmsche Elemente umfassen.

7. Aktive elektronische Filterschaltung nach Anspruch 6, <u>dadurch gekennzeichnet,</u>

daß die steuerbaren, im wesentlichen ohmschen Elemente innerhalb je eines T-Gliedes symmetrisch angeordnet sind.

8. Aktive elektronische Filterschaltung nach einem der vorhergehenden Ansprüche,
<u>gekennzeichnet durch</u>
eine Ausbildung des die Filtercharakteristik bestimmenden Netzwerks als Integrationsstufe.

9. Gerät der elektronischen Nachrichtentechnik,
<u>gekennzeichnet durch</u>
eine aktive elektronische Filterschaltung nach einem der vorhergehenden Ansprüche.

FIG.1

FIG.2

FIG.3

EP 0 981 199 A2